# EUROPEAN PATENT APPLICATION

(11) **EP 2 479 791 A1**
(43) Date of publication of application: **25.07.2012**
(21) Application number: 10817182.8
(22) Date of filing: 15.09.2010
(51) Int. Cl.: H01L 29/786, H01L 21/312, H01L 21/336, H01L 51/05, H01L 51/30, H01L 51/40

(54) **PHOTO-CROSSLINKABLE MATERIAL FOR ORGANIC THIN FILM TRANSISTOR INSULATING LAYER**

(30) Priority: 15.09.2009 JP 2009213200
(71) Applicant: Sumitomo Chemical Co., Ltd, Chuo-ku, Tokyo 104-8260 (JP)
(72) Inventor: YAHAGI, Isao, Tsuchiura-shi Ibaraki 300-0848 (JP)
(74) Representative: Vossius & Partner
(86) International application number: PCT/JP2010/065895
(87) International publication number: WO 2011/034069

(57) **Abstract**

A problem of the present invention is to provide an organic thin film transistor insulating layer material which is capable of forming a cross-linked structure without conducting a treatment at higher temperature, and which enables an organic thin film transistor to have a small absolute value of threshold voltage (Vth) when it is used for the formation of a gate insulating layer. The means for solving the problem is an organic thin film transistor insulating layer material including a macromolecular compound that has a repeating unit having a group containing a fluorine atom and a repeating unit having a photodimerization-reactive group. Preferred examples of the group containing a fluorine atom include an aryl group in which a hydrogen atom has been substituted with a fluorine atom and an alkylaryl group in which a hydrogen atom has been substituted with a fluorine atom, and particularly a phenyl group in which a hydrogen atom has been substituted with a fluorine atom and an alkylphenyl group in which a hydrogen atom has been substituted with a fluorine atom. Preferred examples of the photodimerization-reactive group include an aryl groups in which a hydrogen atom has been substituted with a halomethyl group, and particularly a phenyl group in which a hydrogen atom has been substituted with a halomethyl group.

## Description

### TECHNICAL FIELD

The present invention relates to materials for forming insulating layers and particularly to materials for forming insulating layers of organic thin film transistors.

### BACKGROUND ART

Since organic thin film transistors are more flexible than transistors of inorganic semiconductors and can be produced by a lower temperature process, a plastic substrate or film can be used as a substrate and as a result a device that is lightweight and non-fragile is produced. Moreover, since a device can be produced by the deposition of thin layers using a method of applying or printing a solution containing an organic material in some cases, a large number of devices can be produced on a substrate of large area at low cost.

Furthermore, since there are a wide variety of materials which can be used for the investigation of transistors, a device with a wide range of varied characteristics can be produced if materials differing in molecular structure are used in the investigation.

In electric field effect type organic thin film transistors, which are one type of organic thin film transistors, the voltage applied to a gate electrode acts on a semiconductor layer through a gate insulating layer, thereby controlling on and off of a drain current. Therefore, a gate insulating layer is formed between a gate electrode and a semiconductor layer.

Moreover, organic semiconductor compounds to be used for electric field effect type organic thin film transistors are susceptible to environmental influences such as humidity, oxygen and the like, and therefore transistor characteristics are likely to deteriorate over time due to humidity, oxygen and the like.

Thus, in the structure of a bottom gate type organic thin film transistor device, with an organic semiconductor compound exposed thereon, it is necessary to form an overcoat layer covering the whole structure of the device so as to protect the organic semiconductor compound from being in contact with the open air. On the other hand, in the structure of a top gate type organic thin film transistor device, an organic semiconductor compound is coated and protected with a gate insulating layer.

In this manner, in organic thin film transistors, insulating layer materials are used in order to form the overcoat layer and the gate insulating layer, both of which coat the organic semiconductor layer, and the like. In this specification, an insulating layer or insulating film of an organic thin film transistor such as the above-mentioned overcoat layer and the gate insulating layer is referred to as an organic thin film transistor insulating layer. In addition, a material used to form the organic thin film transistor insulating layer is referred to as an organic thin film transistor insulating layer material. It is to be noted that the material as used herein has a concept including amorphous materials such as macromolecular compounds, macromolecular compound-containing compositions, resins, resin compositions and the like.

The insulating layer material of an organic thin film transistor is required to have such properties as high electrical breakdown strength when having been formed into a thin film, high affinity with an organic semiconductor such that an interface is formed in close contact with the organic semiconductor, high flatness of a film surface at an interface with an organic semiconductor when having been formed into a film on the semiconductor, and the like.

Although investigations have been done on various materials with respect to insulating layer materials to be used for organic thin film transistors, technologies of utilizing organic materials which need neither high temperature conditions nor complicated equipment for insulating layer formation have recently attracted attentions.

For example, Non-Patent Document 1 reports a layer containing poly(4-vinylphenyl-co-methyl methacrylate) (PVP-PMMA) as a gate insulating layer for an organic electric field effect transistor. However, in an organic electric field effect transistor using the above-mentioned resin as an insulating layer, there is a problem that the absolute value of threshold voltage (Vth) is not sufficiently small.

Thus, there is a demand on an insulating layer material which is capable of providing an organic electric field effect transistor whose absolute value of threshold voltage (Vth) is small and from which a laminated structure of an organic layer including an insulating layer can be formed by cross-linking at lower temperature.

### BACKGROUND ART DOCUMENT

### NON-PATENT DOCUMENT

Non-patent Document 1: Appl. Phys. Lett. 92, 183306 (2008)

### SUMMARY OF THE INVENTION

### PROBLEMS TO BE SOLVED BY THE INVENTION

The present invention is to solve the conventional problems described above, and an object thereof is to provide such an insulating layer material of an organic thin film transistor that a cross-linked structure can be formed therein without execution of a treatment at higher temperature and that the resulting organic thin film transistor has a reduced absolute value of threshold voltage in the case that the material is used to form a gate insulating layer.

### MEANS FOR SOLVING THE PROBLEMS

As a result of various investigations in view of the above-mentioned problems, the present invention was accomplished by finding that the above problems are solved by using a specific organic thin film transistor insulating layer material.

That is, the present invention provides an organic thin film transistor insulating layer material comprising a macromolecular compound that has a repeating unit represented by the formula:

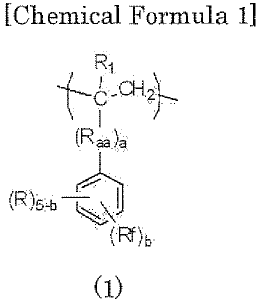

wherein R₁ represents a hydrogen atom or a methyl group; R represents a hydrogen atom or a monovalent organic group having from 1 to 20 carbon atoms; Rf represents a fluorine atom or a monovalent organic group having fluorine atom(s) and from 1 to 20 carbon atoms; Rₐₐ represents a divalent organic group having from 1 to 20 carbon atoms, wherein a hydrogen atom in the divalent organic group may have been substituted with a fluorine atom; a represents an integer of 0 to 20, and b represents an integer of 1 to 5; when there are two or more Rₐₐ's, they may be the same or different; when there are two or more R's, they may be the same or different; and when there are two or more Rf's, they may be the same or different, and a repeating unit represented by the formula:

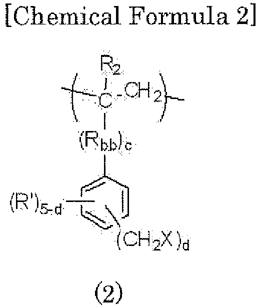

wherein R₂ represents a hydrogen atom or a methyl groups R' represents a hydrogen atom or a monovalent organic group having from 1 to 20 carbon atoms, wherein a hydrogen atom in the monovalent organic group may have been substituted with a fluorine atom; R_{bb} represents a divalent organic group having from 1 to 20 carbon atoms, wherein a hydrogen atom in the divalent organic group may have been substituted with a fluorine atom; c represents an integer of 0 to 20, and d represents an integer of 1 to 5; X represents a chlorine atom, a bromine atom or an iodine atom; when there are two or more R_{bb}'s, they may be the same or different; when there are two or more R's, they may be the same or different; and when there are two or more X's, they may be the same or different.

In one embodiment, in Formula (1), R₁ represents a hydrogen atom or a methyl group; R represents a hydrogen atom; Rf represents a fluorine atom; a represents 0; and b represents an integer of 3 to 5.

In one embodiment, in Formula (2), R₂ represents a hydrogen atom or a methyl group; R' represents a hydrogen atom; c represents 0; d represents 1; and X represents a chlorine atom, a bromine atom or an iodine atom.

In one embodiment, the macromolecular compound further has, as a repeating unit, an ethylene moiety including an aryl group or a phenyl group.

In one embodiment, the macromolecular compound has a molar fraction of the repeating unit represented by Formula (2) of from 0.01 to 0.95.

The present invention provides a method for forming an organic thin film transistor insulating layer comprising the steps of:
applying a liquid containing any of the above-mentioned organic thin film transistor insulating layer materials onto a substrate to form a coat layer; and
irradiating the coat layer with light or an electron beam to crosslink the organic thin film transistor insulating layer material.

In one embodiment, the light is ultraviolet light.

The present invention provides an organic thin film transistor comprising an organic thin film transistor insulating layer formed by using the organic thin film transistor insulating layer material.

In one embodiment, the organic thin film transistor insulating layer is a gate insulating layer.

The present invention provides a member for a display, wherein the member comprises the above-mentioned organic thin film transistor.

The present invention provides a display comprising the above-mentioned member for a display.

### EFFECTS OF THE INVENTION

The organic thin film transistor insulating layer material of the present invention is photosensitive, and is needless to be heated at high temperature in order to form a cross-linked structure. Therefore, the process of forming an insulating layer by using the organic thin film transistor insulating layer material of the present invention does not cause adverse effects on transistor characteristics. Moreover, when the organic thin film transistor insulating layer material of the present invention is used to form a gate insulating layer, the absolute value of threshold voltage of the organic thin film transistor becomes small.

### BRIEF DESCRIPTIONS OF THE DRAWING

[Fig. 1] A schematic cross-sectional diagram illustrating the structure of a bottom-gate type organic thin film transistor which is one exemplary embodiment of the present invention.
[Fig. 2] A schematic cross-sectional diagram illustrating the structure of a top-gate type organic thin film transistor which is another exemplary embodiment of the present invention.

### EMBODIMENT FOR CARRYING OUT THE INVENTION

In this specification, a "macromolecular compound" refers to any compound comprising a structure in which two or more identical structural units are repeated in a molecule, and this includes a so-called dimer. On the other hand, a "low-molecular compound" means any compound that does not have identical structural units repeatedly in a molecule.

### <Organic thin film transistor insulating layer material>

The organic thin film transistor insulating layer material of the present invention is a macromolecular compound or a composition containing a macromolecular compound, including a fluorine atom and a group capable of forming a cross-linked structure without conducting a treatment at higher temperature.

With introduction of fluorine into the organic thin film transistor insulating layer material, the formed insulating layer as a whole is low in polarity and contains little components which are polarized easily when a voltage is applied, so that the polarization of the insulating layer is inhibited. In addition, if a cross-linked structure is formed inside the insulating layer, the movement of the molecular structure is inhibited, and thus the polarization of the insulating layer is inhibited. If the polarization of the insulating layer is inhibited, when, for example, the insulating layer is used as a gate insulating layer, the absolute value of threshold voltage of an organic thin film transistor is lowered and operation accuracy is improved.

A fluorine atom is preferably substituted for a hydrogen atom of a side chain or a side group (a pendant group) of a macromolecular compound, rather than for a hydrogen atom of a main chain of the macromolecular compound. If a fluorine atom has been substituted at the side chain or the side group, affinity with other organic materials such as an organic semiconductor does not deteriorate, and this makes it easy to form a layer in contact with an exposed surface of an insulating layer.

The group capable of forming a cross-linked structure, which is contained in the organic thin film transistor insulating layer material, may be, for example, any group which reacts with each other to allow for dimerization. As to the group which reacts with each other to allow for dimerization, two of these groups are bonded together to successfully form a cross-linked structure inside an insulating layer.

The group which reacts with each other to allow for dimerization is preferably a functional group which absorbs light energy or electron energy to allow a dimerization reaction to be induced (referred to as a "photodimerization-reactive group" in this specification). The reason for this is that there is no need to carry out heating treatment at higher temperature for a long time in order to crosslink the gate insulating layer material, and transistor characteristics are hardly deteriorated in the process of forming an insulating layer.

The light absorbed by the photodimerization-reactive group is preferably high-energy light, since excessively low-energy light may cause the photodimerization-reactive group to react as well in some cases during the formation of an organic thin film transistor insulating layer material by a photopolymerization method. The light absorbed by the photodimerization-reactive group is preferably ultraviolet light, for example, light having a wavelength of 360 nm or less, and preferably from 150 to 300 nm.

The dimerization as used herein refers to the action that two molecules of organic compound(s) are chemically bonded together. The molecules to be bonded together may be the same or different kind. Also, the chemical structures of functional groups in the two molecules may be the same or different. It, however, is preferred that the functional groups have structure(s) and combination, which allow a photodimerization reaction to occur without using reaction aids such as a catalyst, an initiator and the like. The reason for this is that surrounding organic materials may be deteriorated when they are brought into contact with a residue of the reaction aids.

Preferred examples of the group containing a fluorine atom include an aryl group in which a hydrogen atom has been substituted with a fluorine atom and an alkylaryl group in which a hydrogen atom has been substituted with a fluorine atom, and particularly a phenyl group in which a hydrogen atom has been substituted with a fluorine atom and an alkylphenyl group in which a hydrogen atom has been substituted with a fluorine atom. Preferred examples of the photodimerization-reactive group include an aryl group in which a hydrogen atom has been substituted with a halomethyl group, and particularly a phenyl group in which a hydrogen atom has been substituted with a halomethyl group. When the basic structure of a side group of a repeating unit is an aryl group or a phenyl group, affinity with other organic materials such as an organic semiconductor is improved, and this makes it easy to form a flat layer in contact with an exposed surface of an insulating layer.

When the aryl group in which a hydrogen atom has been substituted with a halomethyl group and the phenyl group in which a hydrogen atom has been substituted with a halomethyl group are irradiated with ultraviolet light or an electron beam, halogen is eliminated therefrom to generate benzyl type radicals. Two radicals generated are bonded together to form a carbon-carbon bond (radical coupling), thereby to crosslink the organic thin film transistor insulating layer material.

A preferred embodiment of the organic thin film transistor insulating layer material of the present invention is a macromolecular compound that has the above-mentioned repeating unit represented by Formula (1) and the above-mentioned repeating unit represented by Formula (2) (hereinafter may be referred to as a "macromolecular compound of the present invention").

In Formula (1), R₁ represents a hydrogen atom or a methyl group; R represents a hydrogen atom or a monovalent organic group having from 1 to 20 carbon atoms; Rf represents a fluorine atom or a monovalent organic group having fluorine atom(s) and from 1 to 20 carbon atoms; Rₐₐ represents a divalent organic group having from 1 to 20 carbon atoms, wherein a hydrogen atom in the divalent organic group may have been substituted with a fluorine atom; a represents an integer of 0 to 20 and b represents an integer of 1 to 5; when there are two or more Rₐₐ's, they may be the same or different; when there are two or more R's, they may be the same or different; and when there are two or more Rfs, they may be the same or different.

The divalent organic group having from 1 to 20 carbon atoms may be linear, branched or cyclic; examples thereof include linear aliphatic hydrocarbon groups having from 1 to 20 carbon atoms, branched aliphatic hydrocarbon groups having from 3 to 20 carbon atoms, alicyclic hydrocarbon groups having from 3 to 20 carbon atoms and aromatic hydrocarbon groups having from 6 to 20 carbon atoms in which a hydrogen atom may have been substituted with an alkyl group or the like, and linear hydrocarbon groups having from 1 to 6 carbon atoms, branched hydrocarbon groups having from 3 to 6 carbon atoms, cyclic hydrocarbon groups having from 3 to 6 carbon atoms and aromatic hydrocarbon groups having from 6 to 20 carbon atoms in which a hydrogen atom may have been substituted with an alkyl group or the like are preferred.

Specific examples of the aliphatic hydrocarbon groups include a methylene group, an ethylene group, a propylene group, a butylene group, a pentylene group, a hexylene group, an isopropylene group, an isobutylene group, a dimethylpropylene group, a cyclopropylene group, a cyclobutylene group, a cyclopentylene group, a cyclohexylene group and the like.

Specific examples of the aromatic hydrocarbon groups having from 6 to 20 carbon atoms include a phenylene group, a naphthylene group, an anthrylene group, a dimethylphenylene group, a trimethylphenylene group, an ethylenephenylene group, a diethylenephenylene group, a triethylenephenylene group, a propylenephenylene group, a butylenephenylene group, a methylnaphthylene group, a dimethylnaphthylene group, a trimethylnaphthylene group, a vinylnaphthylene group, an ethenylnaphthylene group, a methylanthrylene group, an ethylanthrylene group and the like.

In one embodiment, Rₐₐ is an ethylene group.

The monovalent organic group having from 1 to 20 carbon atoms may be linear, branched or cyclic and also may be saturated or unsaturated.
Examples of the monovalent organic group having from 1 to 20 carbon atoms include linear hydrocarbon groups having from 1 to 20 carbon atoms, branched hydrocarbon groups having from 3 to 20 carbon atoms, cyclic hydrocarbon groups having from 3 to 20 carbon atoms and aromatic hydrocarbon groups having from 6 to 20 carbon atoms, and preferred examples thereof include linear hydrocarbon groups having from 1 to 6 carbon atoms, branched hydrocarbon groups having from 3 to 6 carbon atoms, cyclic hydrocarbon groups having from 3 to 6 carbon atoms, aromatic hydrocarbon groups having from 6 to 20 carbon atoms and the like.
As to the aromatic hydrocarbon groups having from 6 to 20 carbon atoms, each of the hydrogen atoms in the groups may have been substituted with an alkyl group, a chlorine atom, a bromine atom, an iodine atom or the like.

When R is a monovalent organic group having from 1 to 20 carbon atoms, the monovalent organic group having from 1 to 20 carbon atoms includes no fluorine atom. Specific examples of the monovalent organic group having from 1 to 20 carbon atoms include a methyl group, an ethyl group, a propyl group, a butyl group, a pentyl group, a hexyl group, an isopropyl group, an isobutyl group, a tertiary butyl group, a cyclopropyl group, a cyclobutyl group, a cyclopentyl group, a cyclohexyl group, a cyclopentynyl group, a cyclohexynyl group, a trifluoromethyl group, a trifluoroethyl group, a phenyl group, a naphthyl group, an anthryl group, a tolyl group, a xylyl group, a dimethylphenyl group, a trimethylphenyl group, an ethylphenyl group, a diethylphenyl group, a triethylphenyl group, a propylphenyl group, a butylphenyl group, a methylnaphthyl group, a dimethylnaphthyl group, a trimethylnaphthyl group, a vinylnaphthyl group, an ethenylnaphthyl group, a methylanthryl group, an ethylanthryl group, a chlorophenyl group, a bromophenyl group and the like.

Specific examples of the monovalent organic group having fluorine atom(s) and from 1 to 20 carbon atoms represented by Rf include a pentafluorophenyl group and a trifluoromethylphenyl group.

In Formula (2), R₂ represents a hydrogen atom or a methyl group; R' represents a hydrogen atom or a monovalent organic group having from 1 to 20 carbon atoms; R_{bb} represents a divalent organic group having from 1 to 20 carbon atoms, wherein a hydrogen atom in the divalent organic group may have been substituted with a fluorine atom; c represents an integer of 0 to 20 and d represents an integer of 1 to 5; X represents a chlorine atom, a bromine atom or an iodine atom; when there are two or more R_{bb}'s, they may be the same or different; when there are two or more R's, they may be the same or different; and when there are two or more X's, they may be the same or different.

The definition and specific examples of the monovalent organic group having from 1 to 20 carbon atoms represented by R' are the same as those of the above-mentioned monovalent organic group having from 1 to 20 carbon atoms represented by R. The definition and specific examples of the divalent organic group having from 1 to 20 carbon atoms represented by R_{bb} are the same as those of the above-mentioned divalent organic group having from 1 to 20 carbon atoms represented by Rₐₐ.

In one embodiment, R_{bb} is an ethylene group.

The organic thin film transistor insulating layer material of the present invention can be produced by a method of polymerizing a polymerizable monomer that serves as a raw material of a repeating unit represented by Formula (1) and a polymerizable monomer that serves as a raw material of a repeating unit represented by Formula (2) using a photopolymerization initiator or a thermal polymerization initiator. Among these, a method of polymerizing the monomers using a thermal polymerization initiator is preferred.

Examples of the polymerizable monomer to be used as a raw material of a repeating unit represented by Formula (1) include 2-fluorostyrene, 3-fluorostyrene, 4-fluorostyrene, 2,3,4,5,6-pentafluorostyrene, 2-trifluoromethylstyrene, 3-trifluoromethylstyrene, 4-trifluoromethylstyrene and the like.

Examples of the polymerizable monomer to be used as a raw material of a repeating unit represented by formula (2) include 3-chloromethylstyrene, 4-chloromethylstyrene, 3-bromomethylstyrene, 4-bromomethylstyrene and the like.

The organic thin film transistor insulating layer material of the present invention may be a copolymer that has a repeating unit other than the repeating unit represented by Formula (1) and the repeating unit represented by Formula (2). Such a copolymer can be produced by copolymerizing the polymerizable monomer that serves as a raw material of a repeating unit represented by Formula (1), the polymerizable monomer that serves as a raw material of a repeating unit represented by Formula (2) and a polymerizable monomer that is different from these polymerizable monomers (hereinafter, may be referred to as an "additional polymerizable monomer").

Examples of the additional polymerizable monomer include vinyl acetate, vinyl propionate, vinyl butyrate, vinyl benzoate, vinyl-2-methyl benzoate, vinyl-3-methyl benzoate, vinyl-4-methyl benzoate, vinyl-2-trifluoromethyl benzoate, vinyl-3-trifluoromethyl benzoate, vinyl-4-trifluoromethyl benzoate, vinyl methyl ether, vinyl ethyl ether, vinyl propyl ether, vinyl butyl ether, vinyl phenyl ether, vinyl benzyl ether, vinyl-4-methyl phenyl ether, vinyl-4-trifluoromethyl phenyl ether, styrene, α-methylstyrene, 2,4-dimethyl-α-methylstyrene, o-methylstyrene, m-methylstyrene, p-methylstyrene, 2,4-dimethylstyrene, 2,5-dimethylstyrene, 2,6-dimethylstyrene, 3,4-dimethylstyrene, 3,5-dimethylstyrene, 2,4,6-trimethylstyrene, 2,4,5-trimethylstyrene, pentamethylstyrene, o-ethylstyrene, m-ethylstyrene, p-ethylstyrene, o-chlorostyrene, m-chlorostyrene, p-chlorostyrene, o-bromostyrene, m-bromostyrene, p-bromostyrene, o-methoxystyrene, m-methoxystyrene, p-methoxystyrene, o-hydroxystyrene, m-hydroxystyrene, p-hydroxystyrene, 2-vinylbiphenyl, 3-vinylbiphenyl, 4-vinylbiphenyl, 1-vinylnaphthalene, 2-vinylnaphthalene, 4-vinyl-p-terphenyl, 1-vinylanthracene, o-isopropenyltoluene, m-isopropenyltoluene, p-isopropenyltoluene, 2,4-dimethyl-α-methylstyrene, 2,3-dimethyl-α-methylstyrene, 3,5-dimethyl-α-methylstyrene, p-isopropyl-α-methylstyrene, α-ethylstyrene, α-chlorostyrene, divinylbenzene, divinylbiphenyl, diisopropylbenzene, 4-aminostyrene, 2,3,4,5,6-pentafluorostyrene, 2-trifluoromethylstyrene, 3-trifluoromethylstyrene, 4-trifluoromethylstyrene, acrylonitrile, allyl acetate, allyl benzoate, N-methyl-N-vinylacetamide, 1-butene, 1-pentene, 1-hexene, 1-octene, vinylcyclohexane, vinyl chloride, allyltrimethylgermanium, allyltriethylgermanium, allyltributylgermanium, trimethylvinylgermanium, triethylvinylgermanium, methyl acrylate, ethyl acrylate, n-propyl acrylate, isopropyl acrylate, n-butyl acrylate, isobutyl acrylate, sec-butyl acrylate, hexyl acrylate, octyl acrylate, 2-ethylhexyl acrylate, decyl acrylate, isobornyl acrylate, cyclohexyl acrylate, phenyl acrylate, benzyl acrylate, N,N-dimethylacrylamide, N,N-diethylacrylamide, methyl methacrylate, ethyl methacrylate, n-propyl methacrylate, isopropyl methacrylate, n-butyl methacrylate, isobutyl methacrylate, sec-butyl methacrylate, hexyl methacrylate, octyl methacrylate, 2-ethylhexyl methacrylate, decyl methacrylate, isobornyl methacrylate, cyclohexyl methacrylate, phenyl methacrylate, benzyl methacrylate, N,N-dimethylmethacrylamide, N,N-diethylmethacrylamide, N-acryloylmorpholine, 2,2,2-trifluoroethyl acrylate, 2,2,3,3,3-pentafluoropropyl acrylate, 2-(perfluorobutyl)ethyl acrylate, 3-perfluorobutyl-2-hydroxypropyl acrylate, 2-(perfluorohexyl)ethyl acrylate, 3-perfluorohexyl-2-hydroxypropyl acrylate, 2-(perfluorooctyl)ethyl acrylate, 3-perfluorooctyl-2-hydroxypropyl acrylate, 2-(perfluorodecyl)ethyl acrylate, 2-(perfluoro-3-methylbuty)ethyl acrylate, 3-(perfluoro-3-methylbutyl)-2-hydroxypropyl acrylate, 2-(perfluoro-5-methylhexyl)ethyl acrylate, 2-(perfluoro-3-methylbutyl)-2-hydroxypropyl acrylate, 3-(perfluoro-5-methylhexyl)-2-hydroxypropyl acrylate, 2-(perfluoro-7-methyloctyl)ethyl acrylate, 3-(perfluoro-7-methyloctyl)-2-hydroxypropyl acrylate, 1H,1H,3H-tetrafluoropropylacrylate, 1H,1H,5H-octafluoropentyl acrylate, 1H,1H,7H-dodecafluoroheptyl acrylate, 1H,1H,9H-hexadecafluorononyl acrylate, 1H-1-(trifluoromethyl)trifluoroethyl acrylate, 1H,1H,3H-hexafluorobutyl acrylate, 2,2,2-trifluoroethyl methacrylate, 2,2,3,3,3-pentafluoropropyl methacrylate, 2-(perfluorobutyl)ethyl methacrylate, 3-perfluorobutyl-2-hydroxypropyl methacrylate, 2-(perfluorohexyl)ethyl methacrylate, 3-perfluorohexyl-2-hydroxypropyl methacrylate, 2-(perfluorooctyl)ethyl methacrylate, 3-perfluorooctyl-2-hydroxypropyl methacrylate, 2-(perfluorodecyl)ethyl methacrylate, 2-(perfluoro-3-methylbutyl)ethyl methacrylate, 3-(perfluoro-3-methylbutyl)-2-hydroxypropyl methacrylate, 2-(perfluoro-5-methylhexyl)ethyl methacrylate, 2-(perfluoro-3-methylbutyl)-2-hydroxypropyl methacrylate, 3-(perfluoro-5-methylhexyl)-2-hydroxypropyl methacrylate, 2-(perfluoro-7-methyloctyl) ethyl methacrylate, 3-(perfluoro-7-methyloctyl)-2-hydroxypropyl methacrylate, 1H,1H,3H-tetrafluoropropyl methacrylate, 10H,1H,5H-octafluoropentyl methacrylate, 1H,1H,7H-dodecafluoroheptyl methacrylate, 1H,1H,9H-hexadecafluorononyl methacrylate, 1H-1-(trifluoromethyl)trifluoroethyl methacrylate, 1H,1H,3H-hexafluorobutyl methacrylate and the like.

Among these, as the additional polymerizable monomer, preferred are vinyl monomers having an aryl group, such as styrene, vinyl benzoate, vinylphenylene, vinylnaphthalene, vinylanthracene, allyl benzoate and the like, and particularly preferred are vinyl monomers having a phenyl group, such as styrene, vinyl benzoate, vinylnaphthalene and the like. In this case, the aryl group or phenyl group may have an alkyl group having from 1 to 20 carbon atoms, a hydroxyl group, an amino group, a carboxyl group and the like as a substituent group.

Moreover, in this case, the macromolecular compound of the present invention further has, as a repeating unit other than the repeating unit represented by Formula (1) and the repeating unit represented by Formula (2), an ethylene moiety having an aryl group or a phenyl group. When the phenyl group or the aryl group in the macromolecular compound of the present invention is increased, affinity with other organic materials such as an organic semiconductor is improved, and this makes it easy to form a flat layer in contact with an exposure surface of an insulating layer.

Examples of the photopolymerization initiator include carbonyl compounds, such as acetophenone, 2,2-dimethoxy-2-phenylacetophenone, 2,2-diethoxyacetophenone, 4-isopropyl-2-hydroxy-2-methylpropiophenone, 2-hydroxy-2-methylpropiophenone, 4,4'-bis(diethylamino)benzophenone, benzophenone, methyl(o-benzoyl)benzoate, 1-phenyl-1,2-propanedione-2-(o-ethoxycarbonyl)oxime, 1-phenyl-1,2-propanedione-2-(o-benzoyl)oxime, benzoin, benzoin methyl ether, benzoin ethyl ether, benzoin isopropyl ether, benzoin isobutyl ether, benzoin octyl ether, benzil, benzyl dimethyl ketal, benzyl diethyl ketal, diacetyl and the like; derivatives of anthraquinone or thioxanthone, such as methylanthraquinone, chloroanthraquinone, chlorothioxanthone, 2-methylthioxanthone, 2-isopropylthioxanthone and the like; and sulfur compounds, such as diphenyldisulfide, dithiocarbamate and the like.

When light energy is used as energy to initiate copolymerization, the wavelength of light for irradiation of the polymerizable monomer is 360 nm or more, preferably from 360 to 450 nm.

The thermal polymerization initiator may be any substance that can serve as an initiator of radical polymerization, and examples thereof include azo type compounds, such as 2,2'-azobisisobutyronitrile, 2,2'-azobisisovaleronitrile, 2,2'-azobis(2,4-dimethylvaleronitrile), 4,4'-azobis(4-cyanovaleric acid), 1,1'-azobis(cyclohexanecarbonitrile), 2,2'-azobis (2-methylpropane), 2,2'-azobis(2-methylpropionamidine) dihydrochloride and the like; ketone peroxides, such as methyl ethyl ketone peroxide, methyl isobutyl ketone peroxide, cyclohexanone peroxide, acetylacetone peroxide and the like; diacyl peroxides, such as isobutyl peroxide, benzoyl peroxide, 2,4-dichlorobenzoyl peroxide, o-methylbenzoyl peroxide, lauroyl peroxide, p-chlorobenzoyl peroxide and the like; hydroperoxides, such as 2,4,4-trimethylpentyl-2-hydroperoxide, diisopropylbenzene peroxide, cumene hydroperoxide, tert-butyl peroxide and the like; dialkyl peroxides, such as dicumyl peroxide, tert-butylcumyl peroxide, di-tert-butyl peroxide, tris(tert-butyl peroxy)triazine and the like; peroxyketals, such as 1,1-di-tert-butylperoxycyclohexane, 2,2-di(tert-butyl peroxy)butane and the like; alkyl peroxyesters, such as tert-butyl peroxypivalate, tert-butyl peroxy-2-ethylhexanoate, tert-butyl peroxyisobutylate, di-tert-butyl peroxyhexahydroterephthalate, di-tert-butyl peroxyazelate, tert-butyl peroxy-3,5,5-trimethylhexanoate, tert-butyl peroxyacetate, tert-butyl peroxybenzoate, di-tert-butyl peroxytrimethyladipate and the like; and peroxycarbonates, such as diisopropyl peroxydicarbonate, di-sec-butyl peroxydicarbonate, tert-butyl peroxyisopropylcarbonate and the like.

The organic thin film transistor insulating layer material of the present invention preferably has a weight average molecular weight of from 3000 to 1000000 and more preferably from 5000 to 500000. The organic thin film transistor insulating layer material may be in a linear form, a branched form or a cyclic form.

In the production of the organic thin film transistor insulating layer material of the present invention, the amount to be used of the polymerizable monomer that serves as a raw material of a repeating unit represented by Formula (1) is adjusted so that the amount of fluorine atoms to be introduced to the organic thin film transistor insulating layer material may become an appropriate amount.

The amount of fluorine atoms to be introduced to the organic thin film transistor insulating layer material is preferably from 1 to 60% by weight, more preferably from 5 to 50% by weight and even more preferably from 5 to 40% by weight based on the weigh of the organic thin film transistor insulating layer material. When the amount of fluorine atoms is less than 1% by weight, the effect of reducing the absolute value of threshold voltage of an organic electric field effect transistor may become insufficient, and when it exceeds 60% by weight, the affinity with other organic materials deteriorates, so that it may become difficult to form a layer in contact with an exposure surface of an insulating layer.

The molar amount of the charged polymerizable monomer that serves as a raw material of a repeating unit represented by Formula (1) is, based on the total of all the monomers used in polymerization, 5% by mol or more and 95% by mol or less, more preferably 10% by mol or more and 90% by mol or less and further more preferably 20% by mol or more and 80% by mol or less.

For example, when the polymerizable monomer that serves as a raw material of a repeating unit represented by Formula (1) has from 3 to 5 fluorine atoms, in a preferred embodiment, the molar amount of the charged polymerizable monomer that serves as a raw material of a repeating unit represented by Formula (1) is, based on the total of all the monomers used in polymerization, 10% by mol or more and 70% by mol or less, more preferably 15% by mol or more and 50% by mol or less and further more preferably 25% by mol or more and 35% by mol or less.

In the production of the organic thin film transistor insulating layer material of the present invention, the amount to be used of the polymerizable monomer that serves as a raw material of a repeating unit represented by Formula (2) is adjusted so that the crosslink density of the organic thin film transistor insulating layer material may become appropriate.

The molar amount of the charged polymerizable monomer that serves as a raw material of a repeating unit represented by Formula (2) is, based on the total of all the monomers used in polymerization, preferably 1% by mol or more and 95% by mol or less, more preferably 5% by mol or more and 80% by mol or less and further more preferably 10% by mol or more and 70% by mol or less.

For example, when the polymerizable monomer that serves as a raw material of a repeating unit represented by Formula (2) has one photodimerization-reactive group, in a preferred embodiment, the molar amount of the charged polymerizable monomer that serves as a raw material of a repeating unit represented by Formula (2) is, based on the total of all the monomers used in polymerization, 2% by mol or more and 50% by mol or less, more preferably 3% by mol or more and 25% by mol or less and further more preferably 5% by mol or more and 15% by mol or less.

When the molar amount of the charged polymerizable monomer that serves as a raw material of a repeating unit represented by Formula (2) is less than 1% by mol, the organic thin film transistor insulating layer material may not exhibit sufficient solvent resistance in some cases, and when it is more than 95% by mol, the organic thin film transistor insulating layer material may have poor preservation stability in some cases.

Examples of the organic thin film transistor insulating layer material of the present invention include poly(styrene-co-pentafluorostyrene-co-3-chloromethylstyrene), poly(styrene-co-pentafluorostyrene-co-4-chloromethylstyrene), poly(styrene-co-pentafluorostyrene-co-acrylonitrile-co-3-chloromethylstyrene ), poly(vinyl benzoate-co-pentafluorostyrene-co-3-chloromethylstyrene), poly(vinyl benzoate-co-pentafluorostyrene-co-acrylonitrje-co-3-chloromethylstyrene), poly(styrene-co-pentafluorostyrene-co-methyl methacrylate-co-3-chloromethylstyrene), poly(styrene-co-pentafluorostyrene-co-3-chloromethylstyrene), poly(styrene-co-pentafluorostyrene-co-acrylonitrile-co-4-chloromethylstyrene ), poly(vinyl benzoate-co-pentafluorostyrene-co-4-chloromethylstyrene), poly(vinyl benzoate-co-pentafluorostyrene-co-acrylonitrile-co-4-chloromethylstyrene), poly(styrene-co-pentafluorostyrene-co-methyl methacrylate-co-4-chloromethylstyrene), poly(pentafluorostyrene-co-3-chloromethylstyrene), poly(pentafluorostyrene-ca-4-chloxomethylstyrene), poly(styrene-co-pentafluorostyrene-co-3-bromomethylstyrene), poly(styrene-co-pentafluorostyrene-co-4-bromomethylstyrene), poly(styrene-co-pentafluorostyrene-co-acrylonitrile-co-bromomethylstyren e), poly(vinyl benzoate-co-pentafluorostyrene-co-3-bromomethylstyrene), poly(vinyl benzoate-co-pentafluorostyrene-co-acrylonitrile-co-3-bromomethylstyrene), poly(styrene-co-pentafluorostyrene-co-methyl methacrylate-co-3-bromomethylstyrene), poly(styrene-co-pentafluorostyrene-co-3-bromomethylstyrene), poly(styrene-co-pentafluorostyrene-co-acrylonitrile-co-4-bromomethylstyren e), poly(vinyl benzoate-co-pentafluorostyrene-co-4-bromomethylstyrene) poly(vinyl benzoate-co-pentafluorostyrene-co-acrylonitrile-co-bromomethylstyrene), poly(styrene-co-pentafluorostyrene-co-methyl methacrylate-co-4-bromomethylstyrene), poly(pentafluorostyrene-co-3-bromomethylstyrene), poly(pentafluorostyrene-co-4-bromomethylstyrene) and the like.

The macromolecular compound that has a repeating unit represented by Formula (1) and a repeating unit represented by Formula (2) according to the present invention may be mixed with a compound having two or more amino groups in the molecule thereof and used as a composition for an organic thin film transistor insulating layer. Since an amino group reacts with a halomethyl group at relatively low temperature to cause ammonium quaternization to occur, the compound having two or more amino groups in the molecule thereof serves as a cross-linking agent of the macromolecular compound of the present invention.

### <Compound having two or more amino groups in the molecule thereof>

The compound having two or more amino groups in the molecule thereof that can be used in the present invention may be a macromolecular compound or a low-molecular compound.

The macromolecular compound having two or more amino groups in the molecule thereof can be produced by homopolymerizing a polymerizable monomer having an amino group, or copolymerizing a polymerizable monomer having an amino group with an additional polymerizable monomer.
Examples of the polymerizable monomer having an amino group include 4-aminostyrene, 4-allylaniline, 4-aminophenyl vinyl ether, 4-(N-phenylamino)phenyl allyl ether, 4-(N-methylamino)phenyl allyl ether, 4-aminophenyl allyl ether, allylamine, 2-aminoethyl acrylate and the like.

Examples of the polymerizable monomer to be copolymerized with the polymerizable monomer having an amino group include a polymerizable monomer that is the same as the polymerizable monomer that serves as a raw material of a repeating unit represented by Formula (1) and a polymerizable monomer that is the same as the above-mentioned additional polymerizable monomer to be polymerized with the polymerizable monomer that serves as a raw material of a repeating unit represented by Formula (1) and the polymerizable monomer that serves as a raw material of a repeating unit represented by Formula (2).

Examples of the low-molecular compound having two or more amino groups in the molecule thereof include ethylenediamine, hexamethylenediamine, ortho-phenylenediamine, meta-phenylenediamine, para-phenylenediamine, 1,3-bis(3'-aminophenoxy)benzene, 2,2'-ditrifluoromethylbenzidine, 1,3-bis(3-aminopropyl)-1,1,3,3-tetramethyldisiloxane, 1,4-bis(3-aminopropyldimethylsilyl)benzene 3-(2-aminoethylaminopropyl)tris(trimethylsiloxy)silane and the like.

The organic thin film transistor insulating layer material of the present invention may be appropriately diluted with an organic solvent. The organic solvent is not particularly restricted if it is a good solvent to the organic thin film transistor insulating layer material and is a poor solvent to an organic semiconductor compound, and examples thereof include butyl acetate, 2-heptanone, propylene glycol monomethyl ether acetate and the like.
When the organic thin film transistor insulating layer material of the present invention is used as the composition for an organic thin film transistor insulating layer, the organic solvent is preferably a good solvent to the compound having two or more amino groups in the molecule thereof.

In the composition for an organic thin film transistor insulating layer of the present invention, the weight of the organic solvent is preferably from 50 to 1000 parts by weight based on 100 parts by weight of the total weight of the organic thin film transistor insulating layer material and the compound having two or more amino groups in the molecule thereof.

Moreover, in the composition for an organic thin film transistor insulating layer of the present invention, the weight of the compound having two or more amino groups in the molecule thereof is preferably from 0.1 to 50 parts by weight based on 100 parts by weight of the total weight of the macromolecular compound having a repeating unit represented by Formula (1) and a repeating unit represented by Formula (2).

A leveling agent, a surfactant and the like may be added to the composition for an organic thin film transistor insulating layer of the present invention as necessary.

### <Organic thin film transistor>

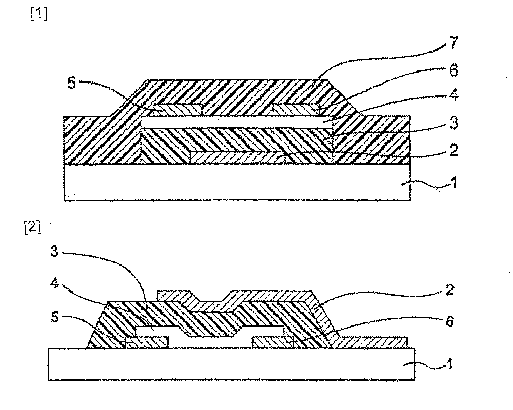

Fig. 1 is a schematic cross-sectional diagram illustrating the structure of a bottom-gate type organic thin film transistor which is one exemplary embodiment of the present invention. This organic thin film transistor has a substrate 1, a gate electrode 2 formed on the substrate 1, a gate insulating layer 3 formed on the gate electrode 2, an organic semiconductor layer 4 formed on the gate insulating layer 3, a source electrode 5 and a drain electrode 6 formed across a channel portion on the organic semiconductor layer 4 and an overcoat layer 7 covering the whole body of the device.

Bottom-gate type organic thin film transistors can be produced by, for example, forming a gate electrode on a substrate, forming a gate insulating layer on the gate electrode, forming an organic semiconductor layer on the gate insulating layer, forming a source electrode and a drain electrode on the organic semiconductor layer and forming an overcoat layer thereon.

Fig.2 is a schematic cross-sectional diagram illustrating the structure of a top -gate type organic thin film transistor which is another exemplary embodiment of the present invention. This organic thin film transistor has a substrate 1, a source electrode 5 and a drain electrode 6 formed on the substrate 1, an organic semiconductor layer 4 formed across a channel portion on these electrodes, a gate insulating layer 3 formed on the organic semiconductor layer 4 and covering the whole body of the device and a gate electrode 2 formed on the surface of the gate insulating layer 3.

The top-gate type organic thin film transistor can be produced by, for example, forming a source electrode and a drain electrode on a substrate, forming an organic semiconductor layer on the source electrode and the drain electrode, forming a gate insulating layer on the organic semiconductor layer and forming a gate electrode on the gate insulating layer.

The formation of the gate insulating layer or the overcoat layer is carried out by preparing the application liquid of an insulating layer material, by, if necessary, further adding a solvent or the like to an organic thin film transistor insulating layer material, applying the application liquid onto the surface of a layer located below the gate insulating layer or the overcoat layer and drying it to cure. The organic solvent to be used for the insulating layer application liquid is not particularly restricted if it can dissolve a macromolecular compound and a cross-linking agent and it is preferably an organic solvent having a boiling point under ordinary pressure of from 100°C to 200°C. Examples of the organic solvent include 2-heptanone, propylene glycol monomethyl ether acetate and the like. A leveling agent, a surfactant, a curing catalyst and the like may be added to the insulating layer application liquid as necessary.

The insulating layer application liquid can be applied onto the gate electrode by conventional spin coating, a die coater, screen printing, inkjet or the like. The formed coat layer is dried as necessary. The drying herein means removal of the solvent of the resin composition applied.

The dried coat is subsequently cured. The curing means cross-linking of the organic thin film transistor insulating layer material. The cross-linking of the transistor insulating layer material is achieved by, for example, allowing two photodimerization-reactive groups to bond together.

When the photodimerization-reactive group is an aryl group or a phenyl group substituted with a halomethyl group, these groups are bonded together by irradiation with light or an electron beam and preferably with ultraviolet light or an electron beam. The wavelength of the light for irradiation is 360 nm or less, preferably from 150 to 300 nm. When the wavelength of the light for irradiation is more than 360 nm, the organic thin films transistor insulating layer material may not achieve sufficient cross-linking in some cases.

The irradiation with ultraviolet light can be carried out by using, for example, an aligner that is in use for the production of semiconductors or a UV lamp that is in use for curing UV-curable resins. The irradiation with an electron beam can be carried out by using, for example, a miniature electron beam irradiation tube. The heating can be carried out by using a heater, oven and the like. Other irradiation conditions and heating conditions are appropriately decided depending on the kind, the amount, and the like of the photodimerization-reactive group.

On the gate insulating layer may be formed a self-assembled monomolecular film layer. The self-assembled monomolecular film layer can be formed by, for example, treating the gate insulating layer with a solution in which from 1 to 10% by weight of an alkylchlorosilane compound or an alkylalkoxysilane compound has been dissolved in an organic solvent.

Examples of the alkylchlorosilane compound include methyltrichlorosilane, ethyltrichlorosilane, butyltrichlorosilane, decyltrichlorosilane, octadecyltrichlorosilane and the like.

Examples of the alkylalkoxysilane compound include methyltrimethoxysilane, ethyltrimethoxysilane, butyltrimethoxysilane, decyltrimethoxysilane, octadecyltrimethoxysilane and the like.

The substrate 1, the gate electrode 2, the source electrode 5, the drain electrode 6 and the organic semiconductor layer 4 may be constituted using materials and methods that are usually used. For example, a plate or a film of resins or plastics, a glass plate, a silicon plate or the like is used for the material of the substrate. The electrodes are formed by a known method, such as a vacuum deposition method, a sputtering method, a printing method, an inkjet method and the like using chromium, gold, silver, aluminum or the like as their material.

π-Conjugated polymers are used widely as an organic semiconductor compound and, for example, polypyrroles, polythiophenes, polyanilines, polyallylamines, fluorenes, polycarbazoles, polyindoles, poly(p-phenylenevinylene)s and the like can be used. Moreover, low-molecular substances soluble in organic solvents, e.g., derivatives of polycyclic aromatics such as pentacene, phthalocyanine derivatives, perylene derivatives, tetrathiafulvalene derivatives, tetracyanoquinodimethane derivatives, fullerenes, carbon nanotubes and the like, can be used. Specific examples include a condensate of 9,9-di-n-octylfluorene-2,7-di(ethylene boronate) and 5,5'-dibromo-2,2'-bithiophene and the like.

The formation of the organic semiconductor layer is carried out by, for example, preparing an organic semiconductor application liquid by, if necessary, adding a solvent or the like to an organic semiconductor compound and applying and drying it. In the present invention, the resin that constitutes the gate insulating layer has a phenyl moiety or a carbonyl moiety and has affinity with an organic semiconductor compound. Therefore, a uniform flat interface is formed between an organic semiconductor layer and a gate insulating layer by the above-mentioned applying drying method.

The solvent to be used is not particularly restricted if it is one that dissolves or disperses organic semiconductors and it is preferably one having a boiling point under ordinary pressure of from 50°C to 200°C. Examples of the solvent include chloroform, toluene, anisole, 2-heptanone, propylene glycol monomethyl ether acetate and the like. Like the above-mentioned insulating layer application liquid, the organic semiconductor application liquid can be applied by conventional spin coating, a die coater, screen printing, inkjet or the like.

On the insulating layer produced by the use of the organic thin film transistor insulating layer material of the present invention, a flat film or the like can be laminated, so that a laminated structure can be easily formed. Moreover, on the insulating layer, an organic electroluminescence device can be mounted well.

By the use of the organic thin film transistor of the present invention, a member for displays that comprises an organic thin film transistor can be produced well. By the use of the member for displays that comprises an organic thin film transistor, a display that comprises the member for displays can be produced well.

The macromolecular compound having a repeating unit represented by Formula (1) and a repeating unit represented by Formula (2) can be also used in application for forming layers included in a transistor other than the insulating layer or layers included in the organic electroluminescence device.

### EXAMPLES

The present invention is described below in more detail by way of Examples, but it is not needless to say that the invention is not limited by the Examples.

### <Example 1>

### (Synthesis of macromolecular compound 1)

A 125-ml pressure-resistant container (produce by ACE) was charged with 20.00 g of styrene (produce by Wako Pure Chemical Industries, Ltd.), 18.66 g of 2,3,4,5,6-pentafluorostyrene (produce by Aldrich), 4.89 g of vinylbenzyl chloride (produce by Aldrich, mixture of 3-chloromethylstyrene and 4-chloromethylstyrene), 0.22 g of 2,2'-azobis(isobutyronitrile) and 65.65 g of 2-heptanone (produce by Wako Pure Chemical Industries, Ltd.) and was sealed tightly after bubbling with nitrogen. Polymerization was carried out in an oil bath of 60°C for 48 hours, so that a viscous solution of macromolecular compound 1 was obtained. The macromolecular compound 1 is used as an organic thin film transistor insulating layer material. The macromolecular compound 1 has the following repeating units. Here, the subscript numbers of parentheses denote the molar fractions of repeating units.

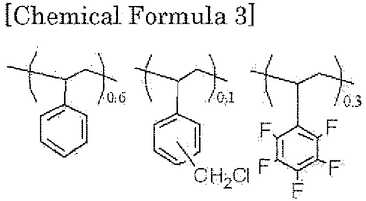

The weight average molecular weight of the resulting macromolecular compound 1 calculated from standard polystyrene was 84000 (GPC manufactured by Shimadzu Corporation, one Tskgel super HM-H and one Tskgel super H2000, mobile phase = THF).

### (Preparation of application solution containing organic thin film transistor insulating layer material and organic solvent)

Into a 10-ml sample bottle were charged 3.00 g of the 2-heptanone solution of the macromolecular compound 1 and 3.00 g of 2-heptanone, which were then stirred to dissolve, so that a homogeneous application solution was prepared.

The resulting application solution was filtered with a membrane filter having a pore diameter of 0.2 µm, to prepare an application solution of the macromolecular compound 1.

### (Production of electric field effect type organic thin film transistor)

F8T2 (copolymer of 9,9-dioctylfluorene : bithiophene = 50 : 50 (molar ratio); polystyrene-equivalent weight average molecular weight = 69,000) was dissolved in chloroform, which was a solvent, to prepare a solution (an organic semiconductor composition) having a concentration of 0.5% by weight, and this was filtered with a membrane filter to prepare an organic semiconductor application liquid.

The application solution of the macromolecular compound 1 was spin-coated on a glass substrate with a chromium electrode, calcined on a hot plate at 150°C for 1 hour and UV-irradiated by using a UV/ozone stripper (manufactured by SAMCO Inc., UV-1) under a nitrogen atmosphere at room temperature (25°C) for two minutes, so that a gate insulating layer of about 390 nm in thickness was obtained. Since the macromolecular compound 1 was capable of cross-linking at lower temperature, it was possible to form the gate insulating layer at lower temperature.

Next, the organic semiconductor application liquid was applied onto the gate insulating layer by a spin coating method to form an active layer of about 60 nm in thickness, and subsequently a source electrode and a drain electrode each having a channel length of 20 µm and a channel width of 2 mm were formed on the active layer by a vacuum deposition method using a metal mask (each of the electrodes having a laminated structure in the order or molybdenum oxide and gold from the active layer side), so that an electric field effect type organic thin film transistor was produced.

### <Transistor characteristics of electric field effect type organic thin film transistor>

For the thus-produced electric field effect type organic thin film transistor, the transistor characteristics thereof were measured by using a vacuum prober (BCT22MDC-5-HT-SCU; manufactured by Nagase Electronic Equipments Service Co., Ltd.) under such conditions that a gate voltage Vg was varied from 20 to -40 V and a source-drain voltage Vsd was varied from 0 to -40 V

The hysteresis of the organic thin film transistor was expressed by a voltage difference between a threshold voltage Vth1 measured when the gate voltage Vg was varied from 0 V to -40 V and a threshold voltage Vth2 measured when the gate voltage Vg was varied from -40 V to 0 V, at a source-drain voltage Vsd of -40 V The results are given in Table 1.

### <Example 2>

### (Synthesis of macromolecular compound 2)

A 50-mol pressure-resistant container (produced by ACE) was charged with 4.00 g of 2,3,4,5,6-pentaflouorostyrene (produced by Aldrich), 0.79 g of vinylbenzyl chloride (produced by Aldrich, mixture of 3-chloromethylstyrene and 4-chloromethylstyrene), 0.10 g of 2,2'-azobis(isobutyronitrile) and 19.53 g of propylene glycol monomethyl ether acetate (produced by Wako Pure Chemical Industries, Ltd.) and was sealed tightly after bubbling with nitrogen. Polymerization was carried out in an oil bath of 60°C for 48 hours, so that a viscous solution of macromolecular compound 2 was obtained. The macromolecular compound 2 is used as an organic thin film transistor insulating layer material. The macromolecular compound 2 has the following repeating units. Here, the subscript numbers of parentheses denote the molar fractions of repeating units.

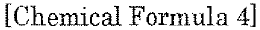

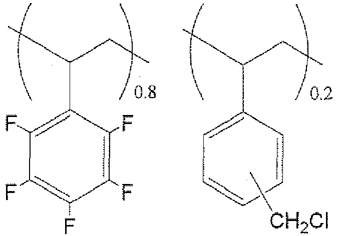

The weight average molecular weight of the resulting macromolecular compound 2 calculated from standard polystyrene was 17000 (GPC manufactured by Shimadzu Corporation, one Tskgel super HM-H and one Tskgel super H2000, mobile phase = THF).

### (Preparation of application solution containing organic thin film transistor insulating layer material and organic solvent)

Into a 10-ml sample bottle were charged 2.00 g of the propylene glycol monomethyl ether acetate solution of the macromolecular compound 2 and 4.00 g of 2-heptanone, which were then stirred to dissolve, so that a homogeneous application solution was prepared.

The resulting application solution was filtered with a membrane filter having a pore diameter of 0.2 µm, to prepare an application solution of the macromolecular compound 2.

### (Production of electric field effect type organic thin film transistor)

An electric field effect type organic thin film transistor was produced in the same manner as in Example 1, except for using the application solution of the macromolecular compound 2. The gate insulating layer was of 430 nm in thickness.

### <Transistor characteristics of electric field effect type organic thin film transistor>

For the thus-produced electric field effect type organic thin film transistor, the transistor characteristics thereof were measured by using a vacuum prober (BCT22MDC-5-HT-SCU; manufactured by Nagase Electronic Equipments Service Co., Ltd.) under such conditions that a gate voltage Vg was varied from 20 to -40 V and a source-drain voltage Vsd was varied from 0 to -40 V

The hysteresis of the organic thin film transistor was expressed by a voltage difference between a threshold voltage Vth1 measured when the gate voltage Vg was varied from 0 V to -40 V and a threshold voltage Vth2 measured when the gate voltage Vg was varied from -40 V to 0 V, at a source-drain voltage Vsd of -40 V. The results are given in Table 1.

### <Example 3>

### (Synthesis of macromolecular compound 3)

A 50-ml pressure-resistant container (produced by ACE) was charged with 5.00 g of 2,3,4,5,6-pentafluorostyrene (produced by Aldrich), 3.93 g of vinylbenzyl chloride (produced by Aldrich, mixture of 3-chloromethylstyrene and 4-chloromethylstyrene), 0.04 g of 2,2'-azobis(isobutyronitrile) and 13.46 g of 2-heptanone (produced by Wako Pure Chemical Industries, Ltd.) and was sealed tightly after bubbling with nitrogen. Polymerization was carried out in an oil bath of 60°C for 48 hours, so that a viscous solution of macromolecular compound 3 was obtained. The macromolecular compound 3 is used as an organic thin film transistor insulating layer material. The macromolecular compound 3 has the following repeating units. Here, the subscript numbers of parentheses denote the molar fractions of repeating units.

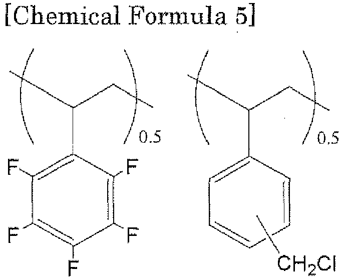

The weight average molecular weight of the resulting macromolecular compound 3 calculated from standard polystyrene was 136000 (GPC manufactured by Shimadzu Corporation, one Tskgel super HM-H and one Tskgel super H2000, mobile phase = THF).

### (Preparation of application solution containing organic thin film transistor insulating layer material and organic solvent)

Into a 10-ml sample bottle were charged 2.00 g of the 2-heptanone solution of the macromolecular compound 3 and 4.00 g of 2-heptanone, which were then stirred to dissolve, so that a homogeneous application solution was prepared.

The resulting application solution was filtered with a membrane filter having a pore diameter of 0.2 µm, to prepare an application solution of the macromolecular compound 3.

### (Production of electric field effect type organic thin film transistor)

An electric field effect type organic thin film transistor was produced in the same manner as in Example 1, except for using the application solution of the macromolecular compound 3. The gate insulating layer was of 260 nm in thickness.

### <Transistor characteristics of electric field effect type organic thin film transistor>

For the thus-produced electric field effect type organic thin film transistor, the transistor characteristics thereof were measured by using a vacuum prober (BCT22MDC-5-HT-SCU; manufactured by Nagase Electronic Equipments Service Co., Ltd.) under such conditions that a gate voltage Vg was varied from 20 to -40 V and a source-drain voltage Vsd was varied from 0 to -40 V.

The hysteresis of the organic thin film transistor was expressed by a voltage difference between a threshold voltage Vth1 measured when the gate voltage Vg was varied from 0 V to -40 V and a threshold voltage Vth2 measured when the gate voltage Vg was varied from -40 V to 0 V, at a source-drain voltage Vsd of -40 V. The results are given in Table 1.

### <Example 4>

### (Synthesis of macromolecular compound 4)

A 50-ml pressure-resistant container (produced by ACE) was charged with 2.00 g of 2,3,4,5,6-pentafluorostyrene (produced by Aldrich), 6.92 g of vinylbenzyl chloride (produced by Aldrich, mixture of 3-chloromethylstyrene and 4-chloromethylstyrene), 0.04 g of 2,2'-azobis(isobutyronitrile) and 12.49 g of 2-heptanone (produced by Wako Pure Chemical Industries, Ltd.) and was sealed tightly after bubbling with nitrogen. Polymerization was carried out in an oil bath of 60°C for 48 hours, so that a viscous solution of macromolecular compound 4 was obtained. The macromolecular compound 4 is used as an organic thin film transistor insulating layer material. The macromolecular compound 4 has the following repeating units. Here, the subscript numbers of parentheses denote the molar fractions of repeating units.

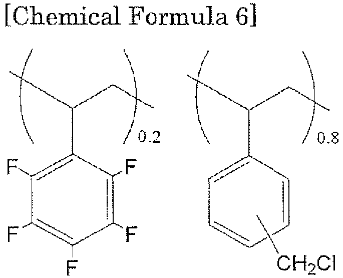

The weight average molecular weight of the resulting macromolecular compound 4 calculated from standard polystyrene was 111000 (GPC manufactured by Shimadzu Corporation, one Tskgel super HM-H and one Tskgel super H2000, mobile phase = THF).

### (Preparation of application solution containing organic thin film transistor insulating layer material and organic solvent)

Into a 10-ml sample bottle were charged 2.00 g of the 2-heptanone solution of the macromolecular compound 4 and 4.00 g of 2-heptanone, which were then stirred to dissolve, so that a homogeneous application solution was prepared.
The resulting application solution was filtered with a membrane filter having a pore diameter of 0.2 µm, to prepare an application solution of the macromolecular compound 4.

### (Production of electric field effect type organic thin film transistor)

An electric field effect type organic thin film transistor was produced in the same manner as in Example 1, except for using the application solution of the macromolecular compound 4. The gate insulating layer was of 220 nm in thickness.

### <Transistor characteristics of electric field effect type organic thin film transistor>

For the thus-produced electric field effect type organic thin film transistor, the transistor characteristics thereof were measured by using a vacuum prober (BCT22MDC-5-HT-SCU; manufactured by Nagase Electronic Equipments Service Co., Ltd.) under such conditions that a gate voltage Vg was varied from 20 to -40 V and a source-drain voltage Vsd was varied from 0 to -40 V.

The hysteresis of the organic thin film transistor was expressed by a voltage difference between a threshold voltage Vth1 measured when the gate voltage Vg was varied from 0 V to -40 V and a threshold voltage Vth2 measured when the gate voltage Vg was varied from -40 V to 0 V, at a source-drain voltage Vsd of -40 V The results are given in Table 1.

### <Comparative Example 1>

### (Production of electric field effect type organic thin film transistor)

Into a 10-ml sample bottle were charged 1.00 g of polyvinylphenol-co-polymethyl methacrylate (produced by Aldrich, Mn = 6700), 0.163 g of N,N,N',N',N",N"-hexamethoxymethylmelamine (produced by Sumitomo Chemical Co., Ltd.), 0.113 g of a thermal acid generator (produced by Midori Kagaku Co., Ltd., commercial name: TAZ-108) and 7.00 g of 2-heptanone, which were then stirred to dissolve, so that a homogeneous application liquid was prepared.

An electric field effect type organic thin film transistor was produced and the transistor characteristics thereof were measured and evaluated in the same manner as in Example 1, except for using this application liquid for the formation of a gate insulating layer and subjecting it to calcination at 200°C. The results are given in Table 1.

**[Table 1]**

| | Hysteresis | Vth1 | ON/OFF |
|---|---|---|---|
| Example 1 | 1.1V | 4.2V | 7.1 × 1.0³ |
| Example 2 | 0.6 V | -2.0 V | 3.3 × 10³ |
| Example 3 | 0.1V | 0.3 V | 3.8 × 10³ |
| Example 4 | 0.4 V | -3.7 V | 1.6 × 10³ |
| Comparative Example 1 | 0.8 V | -21 V | 6.6 × 10⁴ |

### DESCRIPTION OF REFERENCE NUMERALS

- 1:: Substrate
- 2:: gate electrode
- 3:: gate insulating layer
- 4:: organic semiconductor layer
- 5:: source electrode
- 6:: drain electrodes

## Claims

1. An organic thin film transistor insulating layer material comprising a macromolecular compound that has a repeating unit represented by the formula: 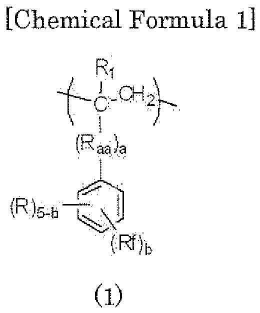 wherein R₁ represents a hydrogen atom or a methyl group; R represents a hydrogen atom or a monovalent organic group having from 1 to 20 carbon atoms; Rf represents a fluorine atom or a monovalent organic group having fluorine atom(s) and from 1 to 20 carbon atoms; Rₐₐ represents a divalent organic group having from 1 to 20 carbon atoms, wherein a hydrogen atom in the divalent organic group may have been substituted with a fluorine atom; a represents an integer of 0 to 20, and b represents an integer or 1 to 5; when there are two or more Rₐₐ's, they may be the same or different; when there are two or more R's, they may be the same or different; and when there are two or more Rf's, they may be the same or different,
and a repeating unit represented by the formula: 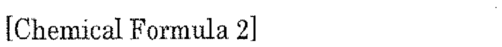 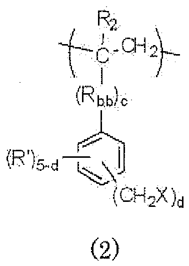 wherein R₂ represents a hydrogen atom or a methyl group; R' represents a hydrogen atom or a monovalent organic group having from 1 to 20 carbon atoms; R_{bb} represents a divalent organic group having from 1 to 20 carbon atoms, wherein a hydrogen atom in the divalent organic group may have been substituted with a fluorine atom; c represents an integer of 0 to 20, and d represents an integer of 1 to 5; X represents a chlorine atom, a bromine atom or an iodine atom; when there are two or more R_{bb}'s, they may be the same or different; when there are two or more R's, they may be the same or different; and when there are two or more X's, they may be the same or different.

2. The organic thin film transistor insulating layer material according to claim 1, wherein, in Formula (1), R₁ represents a hydrogen atom or a methyl group; R represents a hydrogen atom; Rf represents a fluorine atom; a represents 0; and b represents an integer of 3 to 5.

3. The organic thin film transistor insulating layer material according to claim 1 or 2, wherein, in Formula (2), R₂ represents a hydrogen atom or a methyl group; R' represents a hydrogen atom; c represents 0; d represents 1; and X represents a chlorine atom, a bromine atom or an iodine atom.

4. The organic thin film transistor insulating layer material according to any one of claims 1 to 3, wherein the macromolecular compound further has, as a repeating unit, an ethylene moiety including an aryl group or a phenyl group.

5. The organic thin film transistor insulating layer material according to any one of claims 1 to 4, wherein the macromolecular compound has a molar fraction of the repeating unit represented by Formula (2) of from 0.01 to 0.95.

6. A method for forming an organic thin film transistor insulating layer comprising the steps of:
applying a liquid containing the organic thin film transistor insulating layer material according to any one of claims 1 to 5 onto a substrate to form a coat layer; and
irradiating the coat layer with light or an electron beam to crosslink the organic thin film transistor insulating layer material.

7. The method for forming an organic thin film transistor insulating layer according to claim 6, wherein the light is ultraviolet light.

8. An organic thin film transistor comprising an organic thin film transistor insulating layer formed by using the organic thin film transistor insulating layer material according to any one of claims 1 to 5.

9. The organic thin film transistor according to claim 8, wherein the organic thin film transistor insulating layer is a gate insulating layer.

10. A member for a display, wherein the member comprises the organic thin film transistor according to claim 8 or 9.

11. A display comprising the member for a display according to claim 10.
